# FASCICULE DE BREVET EUROPEEN

(11) **EP 0 380 423 B1**
(45) Date de publication et mention de la délivrance du brevet: **09.03.1994**
(21) Numéro de dépôt: 90400223.5
(22) Date de dépôt: 25.01.1990
(51) Int. Cl.: G06K 19/073

(54) **Dispositif de sécurité pour circuit intégré**
Sicherheitsvorrichtung für einen integrierten Schaltkreis
Security device for an integrated circuit

(30) Priorité: 27.01.1989 FR 8900998
(43) Date de publication de la demande: 01.08.1990
(73) Titulaire: GEMPLUS CARD INTERNATIONAL, F-13420 Gémenos (FR)
(72) Inventeur: Kowalski, Jacek, F-75116 Paris (FR)
(74) Mandataire: Schmit, Christian Norbert Marie

(56) Documents cités:
- FR-A- 2 533 047
- FR-A- 2 589 603

## Description

La présente invention a pour objet un dispositif de sécurité pour circuit intégré. Elle est plus particulièrement destinée au domaine des cartes à puce ou la prévention des fraudes s'avère nécessaire.

On connaît déjà des protections de type électrostatique dans lesquelles des circuits de protection protègent les circuits intégrés contre des surtensions. Ces surtensions sont par exemple provoquées, quand on utilise des cartes à puces, par le frottement du support des cartes à puces dans les appareils de lecture, ou dans les vêtements des utilisateurs. Le principe de ces protections est simple. Il consiste à interposer en parallèle avec chaque borne d'accès du circuit intégré une jonction semiconductrice qui se déclenche pour un niveau prédéterminé d'une tension appliquée sur cette borne par rapport à une autre borne (reliée en général au substrat). On a cependant pu observer qu'en certaines circonstances les courants de substrat résultant de la mise en conduction de cette jonction tendent à modifier le fonctionnement du circuit intégré.

Le plus grand soucis des concepteurs de circuits, en particulier pour les cartes à puce, est aujourd'hui la sécurité vis à vis d'un éventuel fraudeur. Cette sécurité peut être obtenue de deux façons. D'une part la sécurité peut être obtenue par le logiciel, d'autre part elle peut être obtenue par le matériel (les circuits). Aucune sécurité n'est complètement efficace. Les circuits à logiques câblées (dans lesquels il n'y a pas de programmation) sont sécurisés uniquement par le matériel, tandis que les circuits à microprocesseur utilisent les deux types de sécurité. En particulier dans les cartes à puce ces deux types de sécurité sont utilisés. En conséquence, une sécurité de type matériel est toujours présente dans les cartes.

La fraude la plus élémentaire d'une carte consiste à modifier le comportement du circuit en utilisant uniquement les bornes du circuit accessibles par un lecteur. Cette fraude simple ne demande pas beaucoup de moyens. Elle est en général facile à mettre en oeuvre. Si le circuit est conçu correctement il n'y a pas de possibilité de fraude de type logique en appliquant des signaux logiques anormaux sur les différentes bornes. Mais par contre rien n'empêche le fraudeur d'appliquer sur les bornes du circuit des niveaux de tension qui sont tout à fait en dehors des spécifications du circuit. Ces niveaux de tension pourraient provoquer des courants de substrat importants qui eux mêmes conduisent à des programmations ou des déprogrammations néfastes du circuit.

Dans les circuits intégrés toutes les bornes sont protégées contre les décharges électrostatiques. Ces protections sont composées principalement de diodes, de transistors bipolaires, et de résistance. Elles permettent d'évacuer les charges présentes sur une borne dès que la tension sur cette borne a dépassé une certaine valeur. Les charges à évacuer sont injectées dans le substrat du circuit. Elles sont ensuite évacuées par une borne de masse à laquelle ce substrat est connecté de loin en loin par une connexion de masse. La protection de type électrostatique a uniquement pour but d'empêcher la soumission des jonctions contenues dans le circuit intégré à des tensions qui pourraient les mener au claquage. Il est donc envisagé qu'un fraudeur pourrait être tenté de soumettre certaines des bornes de connexion du circuit intégré à des surtensions faisant travailler ces circuits de protection électrostatique. Quand ces circuits de protection électrostatique travaillent, des courants de substrat importants ce développent dans le substrat. Ces courants peuvent éventuellement modifier le comportement logique du circuit. En effet, on peut montrer que le courant de substrat peut atteindre facilement un ampère. Au delà d'un ampère, les fils de liaison du circuit intégré au support de carte à puce qui le contient fondent et le circuit devient inutilisable. Mais juste en dessous de cette valeur de un ampère et avec une résistance entre la borne soumise à la surtension et la borne de masse égale à un ohm , on obtient une chute de potentiel de un volt. Dans ce cas la tension du substrat et de la connexion de masse montent localement à un volt par rapport à la borne de masse elle même. Si le signal produit localement à cet endroit du circuit est transmis dans une autre partie du circuit, qui ne serait pas affectée par ce courant, le niveau théorique zéro d'entrée est considéré comme porté à un volt et il peut être détecté comme un 1 logique. On a déjà observé de tels disfonctionnements sur des circuits.

En outre, un phénomène de déclenchement de thyristor parasite (dit latch up) peut se produire dans les technologies de circuits intégrés de type CMOS. De tels problèmes de déclenchements parasites sont mêmes couramment rencontrés quand on injecte sur les bornes de connexion du circuit intégré des tensions négatives par rapport au potentiel imposé sur la borne de masse. Ce phénomène de déclenchement parasite peut conduire un circuit à fonctionner de manière anormale, et peut dans certains cas être même difficile à détecter. Il en résulte que, même sans intention de fraude de la part de l'utilisateur, on peut être confronté à des situations où des disfonctionnements se produisent.

L'invention a pour but de remédier à ces inconvénients en proposant un circuit supplémentaire de validation du fonctionnement du circuit intégré. Ce circuit de validation supplémentaire est censé mesurer la différence de tension ou le courant qui se présentent entre une borne de connexion de ce circuit et des endroits de ce circuit reliés par une connexion à cette borne. Bien entendu, cette protection supplémentaire peut être effectuée de la même façon pour toutes les bornes du circuit. Dans l'invention on associe donc à chaque protection électrostatique un circuit de détection d'anomalies de niveau de tension ou de courant sur la borne de masse associée.

L'invention a donc pour objet un dispositif de sécurité pour circuit intégré caractérisé en ce qu'il comporte des moyens pour invalider le fonctionnement de ce circuit en fonction du courant de substrat qui passe entre une borne de connexion du substrat de ce circuit et des endroits du substrat de ce circuit reliés par une jonction de protection électrostatique à cette borne.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- figure 1 : une représentation schématique d'un dispositif de sécurité conforme à l'invention ;
- figure 2 : une coupe montrant schématiquement l'implantation du dispositif de la figure 1 dans un circuit intégré ;
- figures 3 et 4 : des variantes préférées du dispositif de l'invention avec des transistors à effet de champ ;
- figures 5 et 6 : des schémas d'implantation de circuits intégrés correspondant respectivement aux figures 3 et 4 précédentes.

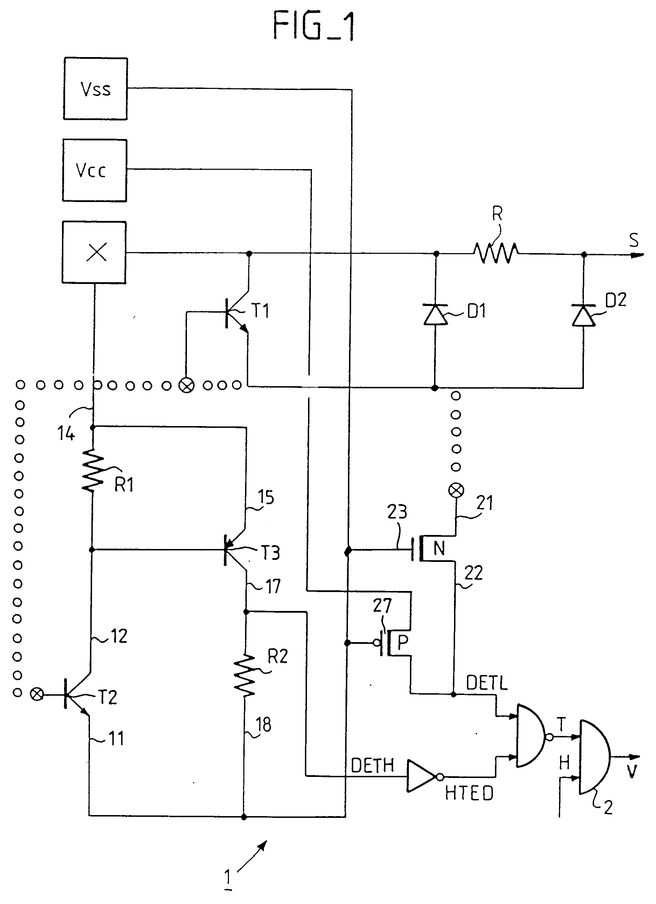

La figure 1 montre, dans un circuit intégré 1 représenté en partie, un dispositif de sécurité conforme à l'invention. Ce dispositif de sécurité est destiné à équiper le circuit intégré. Ce circuit intégré comporte des bornes d'accès. Trois d'entre elles sont montrées : une borne quelconque pour un accès logique X, une borne d'alimentation en tension continue VCC et une borne de connexion à la masse VSS. Ces trois bornes sont destinées à être soumises à des potentiels par des moyens extérieurs de manière à faire fonctionner le circuit intégré. Alors que les tensions de polarisation sont transmises sur les bornes VSS et VCC, des signaux logiques sont transmis par la borne X et aboutissent dans le circuit intégré 1 en un signal S qui y est traité. Dans l'invention, on prévoit un signal de validation V du fonctionnement du circuit intégré. Ce signal de validation pour simplifier les idées pourra être un signal d'horloge H dont la transmission est assurée, au moyen d'une porte ET 2 par exemple, si un signal de test T est présent. Le signal T est présent si on a pu vérifier qu'il n'y avait pas de différence de potentiel ou de courant notables entre la borne VSS de masse, normalement connectée au substrat, et des endroits du substrat de ce circuit reliés par une connexion à cette borne. Cette connexion est notée sur la figure 1 par des petits ronds. Cette connexion n'est pas une connexion équipotentielle parce qu'elle tient compte du fait que si un courant trop important passe à travers elle, elle est le siège d'une chute de tension telle qu'en tous ses points le potentiel est différent.

La borne X est normalement protégée, d'une manière connue, des surtensions électrostatiques par la présence d'un transistor T₁ et de deux diodes D₁ et D₂ placées en parallèle de la voie de transmission du signal S. Si on suppose qu'une tension trop importante est appliquée sur la borne X, l'émetteur du transistor T₁ court-circuité n'est pas porté au potentiel appliqué sur la borne VSS mais, du fait de la chute de tension due au courant de décharge, à un potentiel légèrement plus élevé. Ce potentiel légèrement plus élevé peut être reporté en des parties voisines de ce circuit T₁ D₁ D₂ dans le circuit 1. Il peut y provoquer le déclenchement dans ces parties voisines d'impulsions produisant une programmation néfaste du circuit 1.

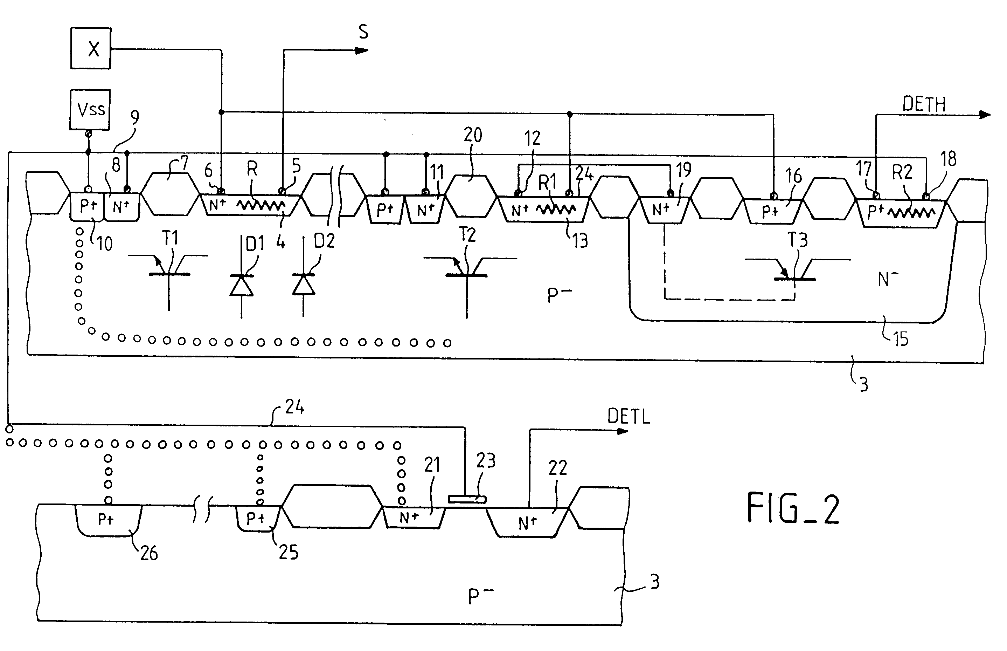

La figure 2, en reprenant les mêmes éléments et numérotation montre schématiquement l'implantation du transistor T₁ et des diodes D₁ et D₂. Dans un substrat semi-conducteur 3 de type P-, on a réalisé une région 4 dopée N+. La région 4 constitue avec le substrat 3 à l'endroit 6 de sa connexion à la borne X, une diode D₁. La région 4 est allongée de façon qu'elle présente une résistance R entre l'endroit de cette connexion et l'endroit d'une prise 5 où est exploité le signal S. Opposé à la connexion 6 par rapport à une zone d'oxyde épais 7 se trouve une autre région 8 également dopé N+. La région 8 forme avec la région 4 à l'endroit de la connexion 6 le transistor T₁. Cette région 8 est reliée par une connexion 9 à une prise 10 de tension substrat. La prise 10 de tension substrat est reliée à la borne de polarisation de substrat VSS.

Lorsqu'un potentiel trop élevé est appliqué sur la borne X, les diodes D₁, D₂ et le transistor T₁ se déclenchent. Il y a un courant très important qui passe dans le substrat 3. On peut considérer que le substrat 3, à l'aplomb de la région d'oxyde 7 constitue la base du transistor T₁ dont l'émetteur est la région 8. Dans l'invention on a remarqué que ce phénomène de déclenchement du transistor se propageait dans des dispositifs du même type, et relativement proches du transistor déclenché T₁. La proximité de ce déclenchement est de l'ordre de 400 micromètres.

Comme ce phénomène se reproduit dans la proximité de T₁, un autre transistor, un transistor T₂, va se mettre à conduire et on va utiliser sa mise en conduction comme signal marquant la présence d'un phénomène anormal. Aussi, à proximité de la borne X et de ces circuits connus T₁, D₁,D₂ de protection électrostatique, on va placer un transistor T₂. Ce transistor T₂ est également un transistor de type bipolaire. Il comporte un émetteur constitué par une région 11 (dopée N+) relié électriquement à la borne VSS. Il comporte un collecteur constitué par la partie 12 d'une région 13 également dopé N+. La région 13 est suffisamment longue pour développer entre sa partie 12 et une autre partie 14 une résistance R₁ de conduction. L'extrémité 14 de la région 13 est reliée à la borne X. Selon ce qui a été indiqué, lorsque le transistor bipolaire T₁ déclenche, le transistor bipolaire T₂ constitué par les régions 11 et 12 déclenche également de sorte que la distance R₁ est maintenant le siège d'une chute de tension significative.

Un autre transistor bipolaire T₃ de type PNP est réalisé dans un caisson 15. Il est relié par son émetteur 16 constitué par une région dopé P+, dans un caisson dopé N- à la borne X. Il est relié par une extrémité 17 de sa région collecteur à une sortie de signal DETH. La région collecteur est assez longue et possède une autre extrémité 18 permettant de développer une résistance de conduction R₂. L'extrémité 18 est relié électriquement à la borne VSS. Le fonctionnement du transistor T₃ est le suivant. Lorsqu'un courant passe dans la résistance R₁, elle est le siège d'une chute de tension. On peut utiliser cette chute de tension pour faire déclencher le transistor T₃ qui fait passer un courant dans la résistance R₂. En conséquence, la tension disponible à l'extrémité 17, ou bien le signal DETH, passent de VSS à une tension liée à la valeur de R₂ et au courant qui traverse R₂. Pour déclencher le transistor T₃ on a ajouté dans le caisson 15 une région 19 dopé N+ qui sert de prise de caisson et qui est relié électriquement au collecteur 12 du transistor T₂. Le transistor T₃ ne fait ici que relayer la détection de courant effectuée à l'endroit du transistor T₂. Ce relais peut être tout différent : notamment le circuit de T₃ peut être remplacé par un circuit à transistors MOS de type N ou P.

Une liaison en tiret montre l'influence du courant caisson ainsi imposé pour déclencher le transistor T₃. On notera que ce type de fonctionnement est favorisé par la présence des régions d'oxyde épais 7, 20 qui séparent l'émetteur et le collecteur des transistors T₁ et T₂ respectivement. En effet, avant de réaliser cette oxydation épaisse, on peut implanter des impuretés P pour augmenter localement la concentration et la transformer de P- en P+. Ceci rend le gain du transistor bipolaire concerné plus important.

On notera que sur la figure 1 les bases des transistors T₁ et T₂ ne sont reliées à la borne VSS qu'à travers une résistance RVSS marquée par une liaison marquée par des petits ronds. Le circuit de l'invention permet donc bien de mesurer le courant qui passe entre la borne VSS de connexion du substrat du circuit intégré, et des endroits du substrat de ce circuit relié par une connexion à cette borne. En effet ces endroits sont les aplombs des régions d'oxyde épais 7 et 20. Ils sont reliés par intermédiaire de la prise de substrat 10 à la connexion VSS.

En ce qui concerne les hautes tensions négatives on utilisera de préférence un transistor à effet de champ plutôt qu'un transistor de type bipolaire pour les détecter. A cette fin, figure 2, un transistor à effet de champ de type N est réalisé en implantant deux régions 21, 22 dopées N+ dans le substrat 3 P- du circuit intégré. Une grille 23 réalisée en polysilicium au dessus d'un oxyde de grille permet de commander le canal de conduction de ce transistor à effet de champ. La grille 23 et la source 21 sont reliées à la borne VSS, le drain 22, polarisé par un circuit de polarisation vu plus loin dispense un signal DETL signalant par son changement d'état la présence d'un défaut.

La particularité de connexion de la région 21 et de la grille 23 est qu'elles ne sont pas connectées à la borne VSS de la même manière. La grille 23 est connectée directement par une métallisation 24 à la borne VSS. Comme la grille d'un transistor à effet de champ ne débite aucun courant on peut admettre que la grille 23 sera en permanence portée au potentiel VSS. Par contre la région source 21 est connectée à VSS d'une autre manière. En effet la connexion de distribution de la tension VSS est reliée de place en place à des prises de substrat telles que 25 et 26. Comme on l'a vu précédemment, par endroit le substrat, du fait de la décharge du transistor T₁ de protection électrostatique, peut être localement porté à un potentiel différent de VSS. C'est à ce potentiel différent qu'est relié la région 21. En définitive dès qu'un problème de différence de tension apparaît dans le substrat (du fait du courant qui passe dans ce substrat) il induit une différence de potentiel telle que le transistor à effet de champ 21-23 se met à conduire et que le signal DETL passe à zéro.

Le circuit de polarisation du détecteur formé par le transistor à effet de champ 21-23 comporte essentiellement une résistance. Cette résistance, dans un exemple, est formée par un transistor 27 à canal N dont le drain est relié à VCC, dont la grille est reliée à VSS, et dont la source est reliée au drain 22 du transistor 21-23. On peut montrer que ce circuit permet de détecter les courants négatifs dans le substrat.

De manière à réaliser la validation du fonctionnement du circuit intégré, le signal DETH passe dans un inverseur pour devenir un signal HTED. Le signal DETL et le signal HTED sont transmis ensemble à une porte NAND délivrant un signal T de validation du fonctionnement d'horloge H. Le circuit de validation présenté ici peut bien entendu prendre tout autre forme et notamment comporter un circuit d'alarme permettant d'avertir l'utilisateur d'un phénomène de déclenchement d'un thyristor parasite.

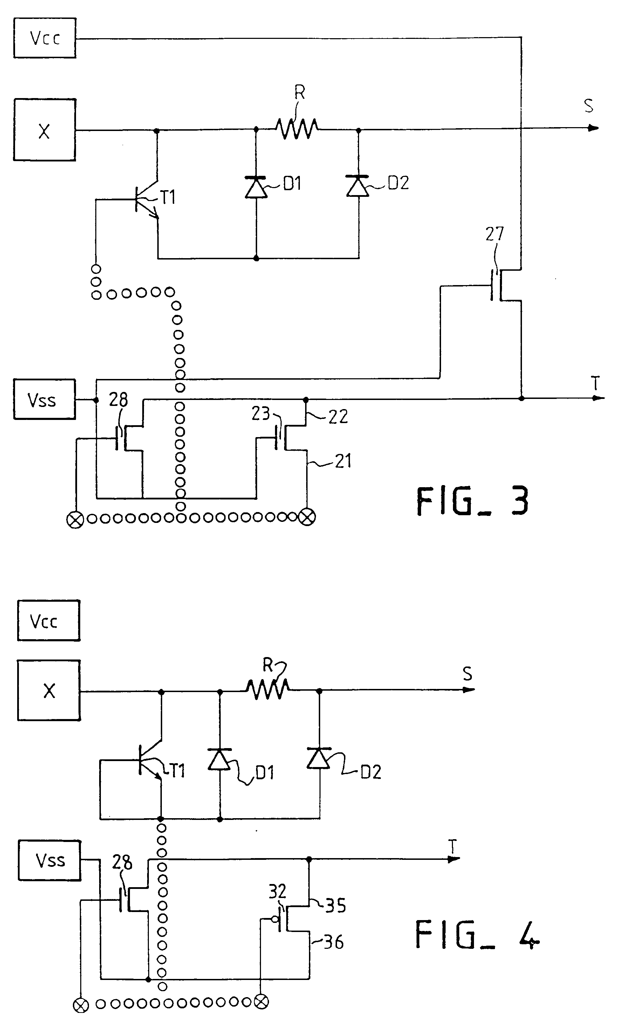

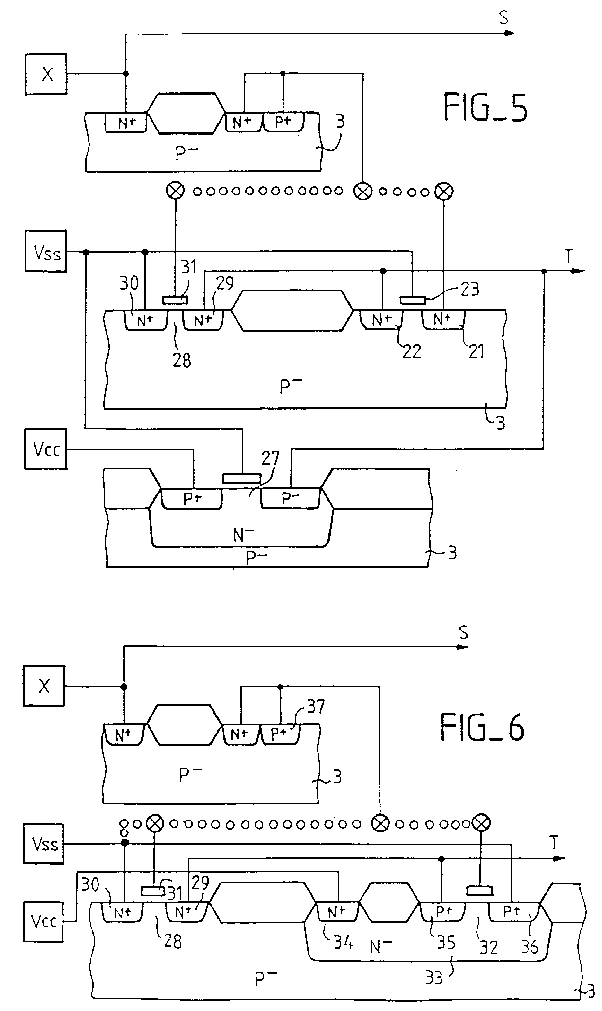

En conservant les mêmes notations, notamment en ce qui concerne la connexion résistive, les figures 3 et 4 montrent des variantes préférées avec des transistors à effet de champ comme détecteurs au lieu de transistors bipolaires. Les circuits de ces figures, sont notablement plus simples puisqu'ils ne comportent plus que des transistors MOS classique (hormis le transistor bipolaire T₁ extérieur au circuit). Le circuit de la figure 3, dont le schéma d'implantation dans le circuit intégré se trouve sur la figure 5, comporte le circuit de protection contre les décharges électrostatiques T₁, D₁, D₂ et R, le transistor 27 de polarisation, et le transistor MOS 21-23. Il comporte en outre un autre transistor MOS 28 de type N comportant une première région 29 dopé N+ dans le substrat 3 P- . Cette région 29 est reliée à la région 22 du transistor 21-23. Cette région 29 est portée à une tension représentant un signal T. Il comporte aussi une autre région 30, également dopée N+, reliée directement à la borne VSS. Les deux régions 29 et 30 sont séparées par un canal de conduction surmonté d'une grille 31 de commande. La grille 31 est reliée à la borne VSS, mais à proximité d'une prise de susbtrat ayant eu à subir des phénomènes de déclenchement des transistors du circuit de protection électrostatique. On peut montrer que si à cet endroit la chute de tension de cette connexion, à la borne VSS est supérieure à 0,7 V le signal T passe à zéro.

Dans la pratique le signal T aboutit sur une connexion commune à un ensemble de dispositifs de protection du même type. Pour des courants de décharge trop forts le signal de détection peut même devenir dans certains cas inférieur à zéro. Il se pourrait qu'il déclenche une petite fuite sur les autres bornes. Ceci n'est pas gênant puisque le circuit intégré est à ce moment invalidé, et qu'en définitive la programmation est interdite. Si on voulait néanmoins éviter ces fuites, on pourrait utiliser à la place du circuit des figures 3 et 5 le circuit des figures 4 et 6, dans lesquelles le transistor 21-23 est remplacé par un transistor 32 de type P monté dans un caisson 33 dopé N-. Le caisson 33 est raccordé par une prise de caisson 34 dopée N+ à la borne VCC. Le transistor 32 comporte une première région 35 reliée à la région 29 du transistor 28 et délivrant le signal T. Il comporte aussi une deuxième région 36 reliée directement à la borne VSS. La liaison à la borne VSS est directe. Les grilles des deux transistors 28 et 32 sont, dans ce cas comme dans le cas précédent, reliées à la borne VSS par l'intermédiaire de la connexion commune de substrat qui de loin en loin plonge par des prises de substrat 37 dans ce substrat 3, et qui est soumise avec celui-ci à des chutes de tension.

## Revendications

1. Dispositif de sécurité pour circuit intégré caractérisé en ce qu'il comporte des moyens (T₂, 2) pour invalider le fonctionnement de ce circuit intégré en fonction du courant de substrat qui passe entre une borne de connexion du substrat de ce circuit et des endroits du substrat de ce circuit reliés par une jonction de protection électrostatique à cette borne.

2. Dispositif selon la revendication 1 caractérisé en ce que les moyens pour invalider comportent un transistor de type bipolaire (T₂), muni de régions émetteur (11) et collecteur (12) situées en regard d'une région de base, cette région de base étant constituée par une partie du substrat (3) de ce circuit intégré à un endroit où ce substrat est soumis à un courant de substrat, ce transistor bipolaire étant relié à un détecteur (R₁, T₃) pour détecter la mise en conduction de ce transistor bipolaire.

3. Dispositif selon la revendication 1 caractérisé en ce que les moyens pour invalider comportent un transistor (28) de type à effet de champ, dont la grille (31) est reliée à une connexion commune de distribution du potentiel de masse du circuit intégré, cette connexion commune étant reliée à une borne de masse (VSS), dont une des régions (30) drain ou source est reliée, par une connexion spécifique, différente de la connexion commune, à la borne de masse, et dont l'autre région (29) source ou drain respectivement est reliée à un détecteur pour détecter la mise en conduction de ce transistor à effet de champ.

4. Dispositif selon la revendication 1 caractérisé en ce que les moyens pour invalider comportent un transistor (21-23) de type à effet de champ dont une région (21) source ou drain est reliée à une connexion commune de distribution du potentiel de masse du circuit intégré, cette connexion commune étant reliée à une borne de masse (VSS), dont la grille (23) est reliée, par une connexion spécifique différente de la connexion commune, à la borne de masse, et dont l'autre région (22) drain ou source respectivement est reliée à un détecteur pour détecter la mise en conduction de ce transistor à effet de champ.

## Patentansprüche

1. Sicherheitsvorrichtung für einen integrierten Schaltkreis, dadurch gekennzeichnet, daß sie eine Anordnung (T₂, 2) aufweist, um die Wirkungsweise dieses integrierten Schaltkreises auszusetzen als Funktion des Substratstromes, der zwischen einem Verbindungsanschluß des Substrates dieses Schaltkreises und denjenigen Stellen des Substrats fließt, die über eine elektrostatische Schutzverbindung mit diesem Anschluß verbunden sind.

2. Vorrichtung nach Anspruch 1, dadurch gekennzeichnet, daß die Aussetzungsanordnung einen bipolaren Transistor (T₂) aufweist, welcher mit Emitterbereichen (11) und Kollektorbereichen (12) versehen ist, gegenüber einem Basisbereich, wobei dieser Basisbereich aus einem Substratabschnitt (3) dieses integrierten Schaltkreises besteht, der an einer Stelle integriert ist, an der das Substrat einem Substratstrom unterworfen wird, wobei der bipolare, Transistor mit einem Detektor (R₁, T₃) verbunden ist, um den leitenden Zustand des bipolaren Transistors festzustellen.

3. Vorrichtung nach Anspruch 1, dadurch gekennzeichnet, daß die Aussetzungsanordnung einen Feldeffekttransistor (28) aufweist, dessen Gitter (31) mit einem gemeinsamen Anschluß zur Verteilung des Massepotentials des integrierten Schaltkreises verbunden ist, wobei dieser gemeinsame Anschluß mit einem Massenanschluß (VSS) verbunden ist, wobei einer der Drain- oder Source-Bereiche (30) über einen eigenen Anschluß unabhängig von dem gemeinsamen Anschluß mit dem Massenanschluß verbunden ist, während der andere Source- bzw. Drain-Anschluß (29) mit einem Detektor verbunden ist, um den leitenden Zustand dieses Feldeffekttransistors festzustellen.

4. Vorrichtung nach Anspruch 1, dadurch gekennzeichnet, daß die Aussetzungsanordnung einen Feldeffekttransistor (21-23) aufweist, dessen einer Source- oder Drain-Bereich (21) mit einem gemeinsamen Anschluß zur Verteilung des Massepotentials des integrierten Schaltkreises verbunden ist, wobei dieser gemeinsame Anschluß mit einem Massenanschluß (VSS) verbunden ist und dessen Gitter (23) über einen eigenen Anschluß unabhängig vom gemeinsamen Anschluß mit dem Massenanschluß verbunden ist, wobei der andere Drain- bzw. Source-Bereich (22) mit einem Detektor verbunden ist, um den leitenden Zustand dieses Feldeffekttransistors festzustellen.

## Claims

1. Security device for an integrated circuit, characterised by the fact that it comprises means (T₂,2) to invalidate the operation of this integrated circuit as a function of the substrate current flowing between a connection terminal of the substrate of this circuit and positions in the substrate of this circuit which are connected by an electrostatic protective connection to the said terminal.

2. Device in accordance with claim 1, characterised by the fact that the means for invalidation comprise a transistor of the bipolar type (T₂) provided with an emitter region (11) and a collection region (12) which are situated opposite a base region, this base region consisting of a part of the substrate (3) of this integrated circuit where this substrate is subjected to a substrate current, this bipolar transistor being connected to a detector (R₁, T₃) serving to detect that this bipolar transistor is made conductive.

3. Device in accordance with claim 1, characterised by the fact that the invalidation means comprise a transistor (28) of the filed effect type of which the gate (31) is connected to a common distribution connection of the earth potential of the integrated circuit, this common connection being connected to an earth terminal (VSS) of which one of the regions, the drain or the source region, is connected by a specific connection, different from the common connection, to the earth terminal, and of which the other region (29), the source or the drain region respectively, is connected to a detector serving to detect that this field effect transistor is made conductive.

4. Device in accordance with claim 1, characterised by the fact that the invalidation means comprise a field effect transistor (21-23) of which one region (21), the source or the drain region, is connected to a common distribution connection of the earth potential of the integrated circuit, this common connection being connected to an earth terminal (VSS) of which the gate (23) is connected, by a specific connection different from the common connection, to the earth terminal, and of which the other region (22), the drain or the source region respectively, is connected to a detector serving to detect that this field effect transistor is made conductive.
